(19) **Europäisches Patentamt**
**European Patent Office**
**Office européen des brevets**

(11) **EP 1 738 391 B1**

(12) **EUROPÄISCHE PATENTSCHRIFT**

(45) Veröffentlichungstag und Bekanntmachung des Hinweises auf die Patenterteilung:
**25.05.2011 Patentblatt 2011/21**

(51) Int Cl.:
*H01J 37/317* (2006.01)    *H01J 37/30* (2006.01)

(21) Anmeldenummer: 05716781.9

(22) Anmeldetag: **24.02.2005**

(86) Internationale Anmeldenummer:
**PCT/EP2005/050781**

(87) Internationale Veröffentlichungsnummer:
**WO 2005/104169 (03.11.2005 Gazette 2005/44)**

(54) **KORREKTURLINSEN-SYSTEM FÜR EIN PARTIKELSTRAHL-PROJEKTIONSGERÄT**

CORRECTION LENS SYSTEM FOR A PARTICLE BEAM PROJECTION DEVICE

SYSTEME DE LENTILLE DE CORRECTION POUR UN APPAREIL DE PROJECTION A FAISCEAU DE PARTICULES

(84) Benannte Vertragsstaaten:
**AT BE BG CH CY CZ DE DK EE ES FI FR GB GR HU IE IS IT LI LT LU MC NL PL PT RO SE SI SK TR**

(30) Priorität: **23.04.2004 DE 102004019834**

(43) Veröffentlichungstag der Anmeldung:
**03.01.2007 Patentblatt 2007/01**

(73) Patentinhaber: **Vistec Electron Beam GmbH 07745 Jena (DE)**

(72) Erfinder:
• **DOERING, Hans-Joachim 07749 Jena (DE)**

• **ELSTER, Thomas 07745 Jena (DE)**

(74) Vertreter: **Freitag, Joachim et al Patentanwälte Oehmke & Kollegen Neugasse 13 07743 Jena (DE)**

(56) Entgegenhaltungen:
**US-A- 4 376 249    US-A- 4 779 046
US-A- 6 005 250    US-B1- 6 222 197**

**Beschreibung**

Die Erfindung betrifft ein Korrekturlinsen-System für ein Partikelstrahl-Projektionsgerät. Im besonderen betrifft die Erfindung ein Korrekturlinsen-System für ein Partikelstrahl-Projektionsgerät mit mindestens einer ersten und einer zweiten magnetischen Linse.

Die europäische Patentschrift EP 0 870 316 B1 offenbart eine mehrteilige magnetische Linse mit konzentrischen Bohrungen, konischen Polschuhen und mit einer Ablenkeinheit. Die Linse ist axialsymmetrisch ausgebildet, und die konische Geometrie des unteren Teils der Linse gestattet es, das magnetische Linsenfeld sehr nah zu dem Substrat zu bringen. Dennoch hat die Linse keine Möglichkeit vorgesehen, dass die Parameter Fokussierung, Maßstabs-Änderung und Strahldrehung separat einstellbar sind. Zur Drehung des Strahls werden üblicherweise langsame Polschuhlinsen verwendet. Außerdem ist bislang die Methode zur Minimierung der durch die Fokussierlinse verursachten Wirbelströme in den Polschuhen der Polschuhlinsen durch Kompensation des Außenfeldes nicht bekannt.

Aus der Patentschrift US 6,222,197 B1 sind Verfahren und Vorrichtung zur Musterprojektion eines geladenen Partikelstrahls bekannt, bei dem in mehreren Teilfeldem auf der Maske Verzerrungsmessmuster enthatten sind, mit denen die Bildverzerrungen gemessen und zur Korrektur von Fokussierfehlern und Astigmatismuskompensation verwendet werden. Dabei werden eine Vielzahl von Korrekturlinsen zwischen Magnetlinsen und Partikelstrahl eingesetzt, die Rotations-, Vergrößerungs- und Fokussierfehler korrigieren können, jedoch sind auch hierbei keine Maßnahmen gegen Wirbetstromentstehung und damit verbundene korrekturverlangsamende Hystereseeffekte vorgesehen.

Der Erfindung liegt die Aufgabe zugrunde, für ein Partikelstrahl-Projektionsgerät zur Belichtung von Substraten (z.B. Wafer) ein magnetisches Korrekturlinseri-System zu gestalten, mit dem es hochgenau und schnell möglich ist, die Fokussierung des Partikelstrahls auf die Targetoberfläche sowie die Drehung des Partikelstrahls und den Abbildungsmaßstab einzustellen.

Diese Aufgabe wird durch ein Korrekturlinsen-System mit den Merkmalen des Anspruchs 1 gelöst.

Es ist von besonderem Vorteil, dass während der kontinuierlichen Objektbewegung im Verlaufe der Belichtung die Korrektur durchgeführt wird. Der Vorteil der erfindungsgemäßen Anordnung ist, dass die Fokussierung, der Abbildungsmaßstab und die Drehung des Strahls kontinuierlich eingestellt werden können. Dabei können die drei Funktionen Fokussierung, Abbildungsmaßstab und Strahldrehung separat, unter Konstanthaltung der jeweils anderen beiden Funktionen, erfolgen. Bei der Fokussierung kann es sich dabei um eine Raumladungs-Nachfokussierung oder auch um eine Nachfokussierung als Folge einer im Verlaufe der Belichtung geringfügig geänderter Objekthöhe (Restunebenheit des Wafers, Tischhöhenfehler) handeln. Die besagten Funktionen erfolgen sehr schnell, und die Wirbelströme im Inneren der Polschuhe der Linsen sollen dabei möglichst keine Verzögerung bewirken.

Es ist von Vorteil, wenn ein Korrekturlinsen-System für ein Partikelstrahl-Projektionsgerät vorgesehen ist. Das Partikelstrahl-Projektionsgerät umfasst mindestens eine erste und eine zweite magnetischen Linse. Es sind mehrere Korrekturlinsenpaare zwischen der ersten und der zweiten magnetischen Linse und dem Partikelstrahls angeordnet. Es hat sich als besonders vorteilhaft erwiesen, ein erstes, ein zweites und ein drittes Korrekturlinsenpaar vorzusehen. Jedes Korrekturlinsenpaar besteht aus einer schnellen Korrekturspule und einer Kompensationsspule.

Die Anordnung der Korrekturlinsenpaare ist derart, dass die Korrekturspule eines jeden Korrekturlinsenpaares näher zum Partikelstrahl angeordnet ist als die jeweils zugeordnete Kompensationsspule.

Weitere vorteilhafte Ausgestaltungen der Erfindung können den Unteransprüchen entnommen werden.

In der Zeichnung ist der Erfindungsgegenstand schematisch dargestellt und wird anhand der Figuren nachfolgend beschrieben. Dabei zeigen:

Fig. 1 eine schematische Darstellung des Aufbaus einer gesamten Partikelstrahlsäule;

Fig. 2 eine schematische Ansicht des unteren Teils des Partikeloptik-Projektionssystems mit vorzugsweise magnetischen Linsen;

Fig. 3 eine schematische Darstellung der Anordnung mehrerer Korrekturlinsen mit jeweils dazugehöriger Kompensationsspule;

Fig. 4 eine Darstellung des Verlaufs der Fokussier-Empfindlichkeit bei verschiedenen Lagen einer Fokussierlinsen-Stufe;

Fig. 5 eine Darstellung des Verlaufs der Maßstabs-Empfindlichkeit bei verschiedenen Lagen einer Fokussierlinsen-Stufe;

Fig. 6 eine Darstellung des Verlaufs der Dreh-Empfindlichkeit bei verschiedenen Lagen einer Fokussierlinsen-Stufe;

Fig. 7 eine Veranschaulichung des Magnetfeldes in der Umgebung einer Korrekturlinse;

Fig. 8 eine Veranschaulichung der Wirkung einer Kompensationsspule einer Korrekturlinsen-Stufe.

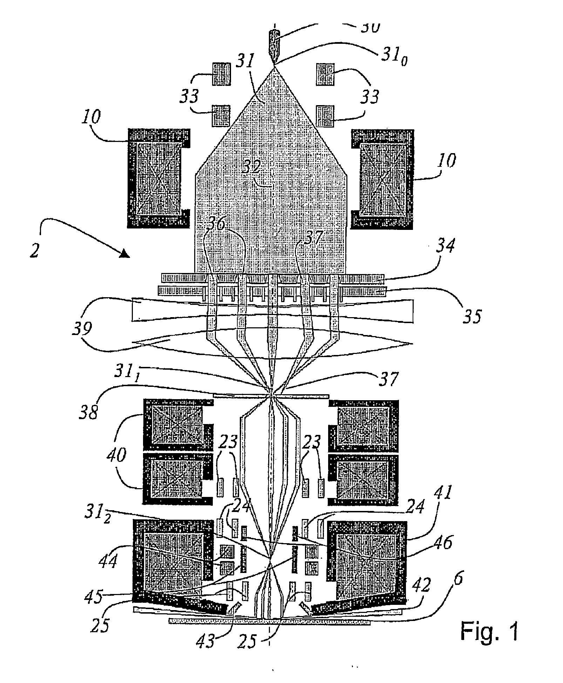

Fig. 1 zeigt den prinzipiellen Strahlengang in einem Partikeloptik - Projektionssystem 2. In der nachstehenden Beschreibung wird das Partikeloptik - Projektionssystem 2 beschrieben, dabei sind die Partikel Elektronen. Von einer Elektronenkanone (Partikelkanone) 30 wird ein Elektronenstrahl 31 erzeugt, der sich in Richtung einer elektronenoptischen Achse 32 ausbreitet. Die aus der Elektronenkanone 30 austretenden Elektronen weisen einen Quell-Crossover $31_0$ auf. Der Elektronenkanone 30 ist eine Strahlzentriereinrichtung 33 nachgeschaltet, die den Elektronenstrahl 31 symmetrisch um die optische Achse 32 ausrichtet. Nach der Strahlzentriereinrichtung durchläuft der Elektronenstrahl 31 einen Beleuchtungskondensor 10, der aus dem anfänglich divergenten Elektronenstrahl 31 einen parallelen Strahl formt. Der durch den Beleuchtungskondensor 10 geformte Strahl besitzt einen Durchmesser, über den die Intensität homogen verteilt ist. Nach dem Beleuchtungskondensor 10 ist eine Aperturplatte 34, mit einer Vielzahl von Öffnungen zur Erzeugung vieler paralleler Strahlenbündel 36, vorgesehen. In Ausbreitungsrichtung der Strahlenbündel 36 hin zum Target 6 folgt eine Ablenkplatte 35, die eine Vielzahl von Strahlablenkeinheiten besitzt. Nach der Ablenkplatte 35 folgt eine Beschleunigungslinse 39, die die Energie der Elektronen im Elektronenstrahl 31 erhöht und dann ein erstes Zwischenbild des Crossovers $31_1$ am Ort der Aperturblende 38 erzeugt. Alle individuellen Crossover der Teilstrahlenbündel 36 entstehen nahezu am gleichen Ort, nämlich der Blendenöffnung der Aperturblende 38. Der Durchmesser der Öffnung der Aperturblende 38 ist dabei so gewählt, dass nahezu alle Elektronen der unabgelenkten Strahlenbündel 36 die Aperturblende 38 passieren können. Einzelstrahlen 37, die durch die Ablenkplatte 35 eine individuelle Richtungsänderung erfahren haben, werden an der Aperturblende 38 gestoppt, da ihr Crossover-Zwischenbild nicht am Ort der Austastblendenöffnung entsteht. Im weiteren Strahlverlauf folgt jetzt mindestens eine magnetische Linse 40 zwecks verkleinerter Abbildung der Aperturplatte 34 auf das Target 6. In dem hier dargestellten Ausführungsbeispiel sind zwei magnetische Linsen 40 gezeigt. Bei der Abbildung entsteht ein zweites Zwischenbild des Crossovers $31_2$. Bevor die unabgelenkten Strahlenbündel 36 auf das Target 6 treffen, das z.B. ein Wafer ist, durchlaufen sie eine Objektivlinse 41. Die Objektivlinse 41 ist mit einer Vielzahl von Elementen ausgestattet. Vor und nach einem zweiten Crossover $31_2$ des Elektronenstrahls 31 sind zwei Ablenkeinrichtungen 45 und 46 vorgesehen. Die Ablenkeinrichtungen 45 und 46 dienen zum Auslenken und zur Lagebestimmung des Elektronenstrahls 31 bzw. der Vielzahl der unabgelenkten Strahlenbündel 36 im Target. Die zwei unabhängig steuerbaren Ablenksysteme 45 und 46 werden vorteilhaft dazu benutzt, um langsame und schnelle Ablenkvorgänge separat optimal zu gestalten. Schnelle Ablenkvorgänge im Frequenzgebiet MHz bis GHz sind z.B. erforderlich, um mittels sägezahnförmiger Ablenkung die Position der verkleinerten Aperturplatte 34 auf dem gleichförmig bewegten Target 6 für die Zeitdauer eines Belichtungsschritts konstant zu halten und anschließend in sehr kurzer Zeit zum nächsten Belichtungspunkt zu springen. Da benachbarte Pixel typisch kleiner als 100nm entfernt sind, wird das schnelle Ablenksystem 46 bevorzugt als elektrostatisches System aufgebaut. Für die Kompensation niederfrequenter Positionsabweichungen des Targets 6 von der gleichförmigen Bewegung im Bereich von einigen Mikrometern kommt bevorzugt ein langsames aber hochgenaues magnetisches Ablenksystem 45 zum Einsatz. Ferner sind Stigmatoren 44 vorgesehen, die bevorzugt als mehretagige magnetische Spulensysteme aufgebaut sind, um Astigmatismen und Verzeichnungen, die in der optischen Säule durch Fertigungstoleranzen und Justagefehler bedingt sind, auszugleichen. Die Objektivlinse 41 besitzt ein am Landepunkt des Elektronenstrahls am Target 6 abtastendes Höhenmeßsystem 42. Das Höhenmeßsystem dient der Erfassung von Unebenheiten des Targets 6 (z.B. Wafer) sowie von Höhenschwankungen die ein Verschiebetisch verursachen kann. Ein Detektor 43 für die vom Target 6 rückgestreuten Partikel befindet sich nahe dem Strahlauftreffpunkt. Dieser Detektor 43 dient der Positionsermittlung von Marken auf einem Target 6 zum Zwecke der Überdeckung mehrerer Belichtungsebenen bzw. zur Kalibrierung von Steuerelementen einer Belichtungsanlage. Weiterhin befinden sich drei Korrekturlinsenpaare 23, 24, 25 im unteren Bereich des Projektionssystems der korpuskularoptischen Säule. Die Korrekturlinsen 23, 24, 25 dienen der dynamischen Korrektur des Fokus, der Bildfeldgrösse und der Bildfeldrotation während der Belichtung des kontinuierlich bewegten Targets 6. Das Korrekturlinsensystem 23, 24, 25 ermöglicht die Korrektur von Fehlern, die durch Höhenschwankungen des Targets, sowie durch veränderliche Raumladung im Säulenbereich hervorgerufen werden.

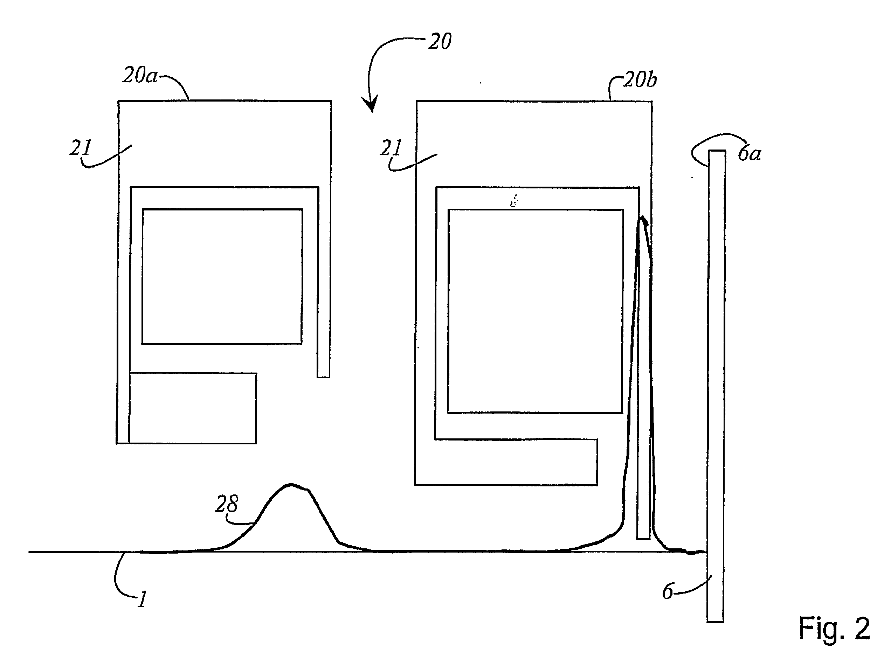

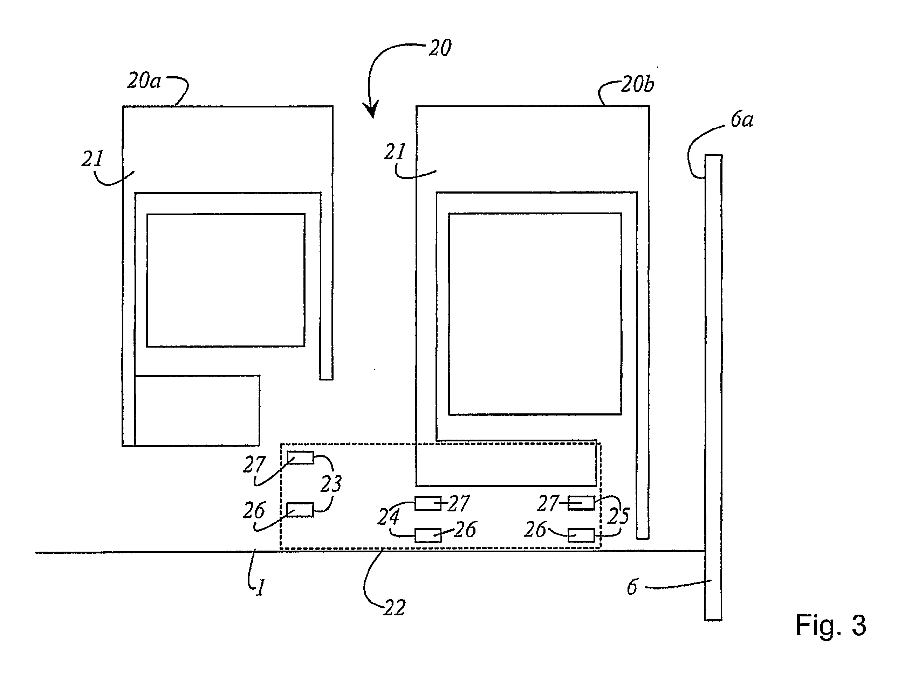

Fig. 2 zeigt eine schematische Ansicht des Partikeloptik-Projektionssystems 20 mit vorzugsweise einer ersten und einer zweiten magnetischen Linse 20a und 20b. Die erste und zweite magnetische Linse 20a und 20b sind im Strahlengang der korpuskularoptischen Projektionsoptik angeordnet. (Abbildung des Objektes (Maske oder Vielstrahl-Modulator) auf die Targetebene bzw. Targetoberfläche 6a). Vorzugsweise umfasst die erste und zweite magnetische Linse 20a und 20b je zwei Polschuhe 21. In der Darstellung der Fig. 2 und Fig. 3 sind nur die erste und zweite magnetische Linse 20a und 20b auf einer Seite des Partikelstrahls 1 dargestellt. Die Linsen 20a und 20b sind rotationssymmetrisch um den Partikelstrahl 1 angeordnet. Die von der ersten und der zweiten magnetische Linse 20a und 20b erzeugte magnetische Achsfeldstärke 28 ist in Fig. 2 auf der durch den Partikelstrahl 1 definierten Achse dargestellt.

Fig. 3 zeigt die Anordnung des erfindungsgemäßen Korrekturlinsen-Systems 22, das in Fig. 3 mit einem gestrichenen Kasten gekennzeichnet ist. Das Korrekturlinsen-System 22 umfasst mehrere Korrekturlinsenpaare 23, 24 oder 25. Vorzugsweise besteht, wie in dieser Ausführungsform gezeigt, das Korrekturlinsen-System 22 aus einem ersten, zweiten und dritten Korrekturlinsenpaar 23, 24 und 25. Die drei Korrekturlinsenpaare 23, 24 und 25 sind als Luftspulenpaare ausgebildet. Jedes Korrekturlinsenpaar 23, 24 oder 25 besteht aus einer schnellen Korrekturspule 26 und einer Kompensationsspule 27. Die Korrekturspule 26 eines jeden Korrekturlinsenpaares 23, 24 und 25 ist näher zum Partikelstrahl 1 angeordnet als die der Korrekturspule 26 zugeordneten Kompensationsspule 27.

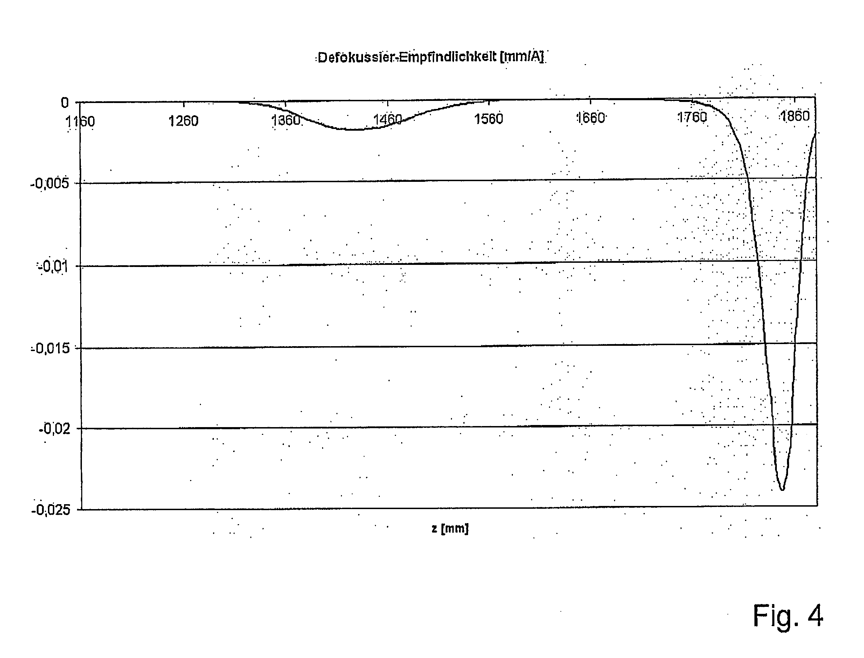

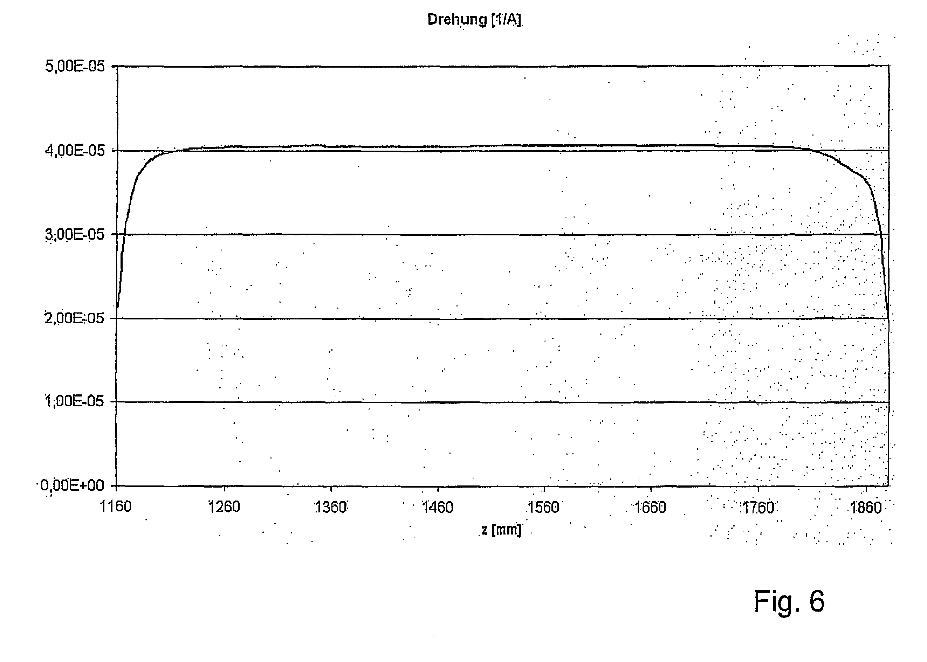

Die Stufen des Korrekturlinsen-Systems 22 sind dabei bezüglich ihrer Lage über dem Target 6 und der Windungszahl derart auszugestalten, dass die Funktionen Fokussierung, Abbildungsmaßstab und Drehung weitgehend entkoppelt sind, d. h. dass bei Einstellung eines dieser Parameter die anderen beiden möglichst unverändert bleiben. Das erste Korrekturlinsenpaar 23 ist für die Änderung des Abbildungsmaßstabes verantwortlich. Das zweite Korrekturlinsenpaar 24 ist für die Drehung des Bildes verantwortlich. Das dritte Korrekturlinsenpaar 25 ist für die Änderung der Fokussierung verantwortlich. Hierzu kann vorteilhaft der Verlauf der Fokussier-, Maßstabs- und Drehempfindlichkeit einer Korrekturlinsen-Stufe als Funktion der Höhenlage dieser Stufe über Target 6 herangezogen werden. Die Figuren 4, 5, und 6 zeigen beispielhaft einen solchen Verlauf.

Fig. 4 zeigt die Fokussierempfindlichkeit als Funktion der Höhenlage einer Korrekturlinsen-Spule. Die Fokussierung des korpuskularoptischen Strahls auf das Target 6 soll vorwiegend mit der dritten Stufe erfolgen, da das Maximum der Fokussierempfindlichkeit in der Spaltmitte der zweiten Linse 20b liegt.

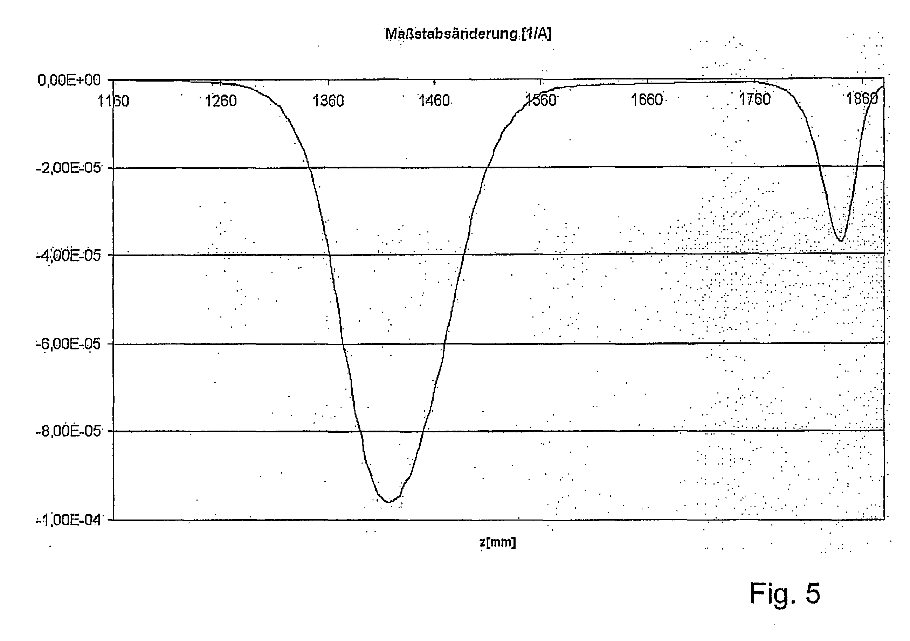

In Fig. 5 ist die Änderung des Abbildungsmaßstabes dargestellt. Die Änderung des Abbildungsmaßstabes soll vorwiegend mit dem ersten Korrekturlinsenpaar 23 erfolgen, das im Maximum der Maßstabsänderungs-Empfindlichkeit in der Spaltmitte der ersten Linse 20a angeordnet ist.

Schließlich soll die Änderung der Strahldrehung vorwiegend mit dem zweiten Korrekturlinsenpaar 24 erfolgen, deren Höhe bzw. Abstand vom Target 6 so gewählt ist, dass hierbei Fokussierung und Maßstabsänderung weitestgehend unverändert bleiben. So ist zwischen der ersten und der zweiten Linse 20a und 20b des Partikeloptik-Projektionssystems der Einfluß des zweiten Korrekturlinsenpaars 24 bezüglich der Drehung des Bildfeldes konstant.

Da die vollständige Entkopplung der Funktionen der Fokussierung, der Maßstabsänderung und der Strahldrehung durch Wahl geeigneter Abstände der Korrekturlinsenpaare 23, 24 und 25 über dem Target 6, auch bedingt durch unvermeidliche Baufehler, nur näherungsweise gelingt, werden die Ströme für die drei Korrekturlinsenpaare 23, 24 und 25 aus einem Gleichungssystem ermittelt, welches drei unabhängige Aussagen zur Wirkung der Ströme auf die Fokussierung, den Abbildungsmaßstab sowie die Strahldrehung beinhaltet. Der Zusammenhang zwischen der Fokussierung z, Änderung des Abbildungsmaßstabes M, Drehänderung θ und den drei Strömen $I_1$, $I_2$ und $I_3$ der Korrekturlinsen-Etagen ist dabei gegeben durch die Matrixgleichung:

$$\begin{pmatrix} \Delta z \\ \Delta M \\ \Delta \Theta \end{pmatrix} = \begin{pmatrix} a_{11} a_{12} a_{13} \\ a_{21} a_{22} a_{23} \\ a_{31} a_{32} a_{33} \end{pmatrix} * \begin{pmatrix} I_1 \\ I_2 \\ I_3 \end{pmatrix}$$

Die exakten Koeffizienten für die Koppelmatrix werden jeweils experimentell mittels einer Kalibrierung bestimmt. Es ist weiterhin möglich, dass der Zusammenhang zwischen z, M, θ und den drei Strömen $I_1$, $I_2$ und $I_3$ nichtlinear ist. In diesem Fall sind für die Abhängigkeiten Polynome zu verwenden.

Wie aus Fig. 3 ersichtlich ist, umfassen die drei Korrekturlinsenpaare 23, 24 und 25 jeweils eine Kompensationsspule 27, die die Aufgabe hat, das Magnetfeld nach außen, also von der Achse 1 weg, stark zu unterdrücken. Die Entstehung von Wirbelströmen z.B. im Eisen der Polschuhe 21 der ersten und zweiten magnetischen Linse 20a und 20b wird dadurch reduziert. Außerdem werden Hystereseeffekte in den Polschuhen 21 oder anderen Ferromagnetika (weichmagnetische Ferrite) minimiert, womit hochgenaue und schnelle Korrekturvorgänge ermöglicht werden. Die Radien $R_{kom}$ der Kompensationsspulen 27 besitzen zu den Radien $R_{fl}$ der jeweiligen Korrekturspulen 26 einen Wert für das Verhältnis $\frac{R_{kom}}{R_{fl}}$, der zwischen 1,5 und 3,0 liegt. Vorzugsweise sollte Wert für das Verhältnis $\frac{R_{kom}}{R_{fl}}$ zwei sein.

Die Abstände der Kompensationsspulen 27 über Target 6 sollten mit dem Abstand der schnellen Korrekturspulen 26 des Korrekturlinsen-Systems über dem Target 6 vorzugsweise übereinstimmen. Für diesen Fall gilt dann nachfolgende einfache Bedingung für die optimale Erregung *NI* (wobei N die Windungszahl und I der Strom ist) der - Korrekturspulen und Kompensationsspulen: $\frac{NI_{kom}}{NI_{fl}} = \left( \frac{RI_{kom}}{RI_{fl}} \right)^2$. Dabei sind die Stromflussrichtungen in den Kompensationsspulen 27 und in den zugeordneten schnellen Korrekturspulen 26 zueinander umgekehrt.

Je nach Ausführungsform und Umgebung des Korrekturlinsen-Systems 22 kann es nützlich sein, die Spulen des Systems mehr oder weniger vollständig durch weichmagnetische Ferrite zu kapseln, um Wirbelströme in den Polschuhen 21 der ersten und zweiten Linse 20a und 20b und anderen leitfähigen Teilen des Partikeloptik-Projektionssystems 20 zu unterdrücken.

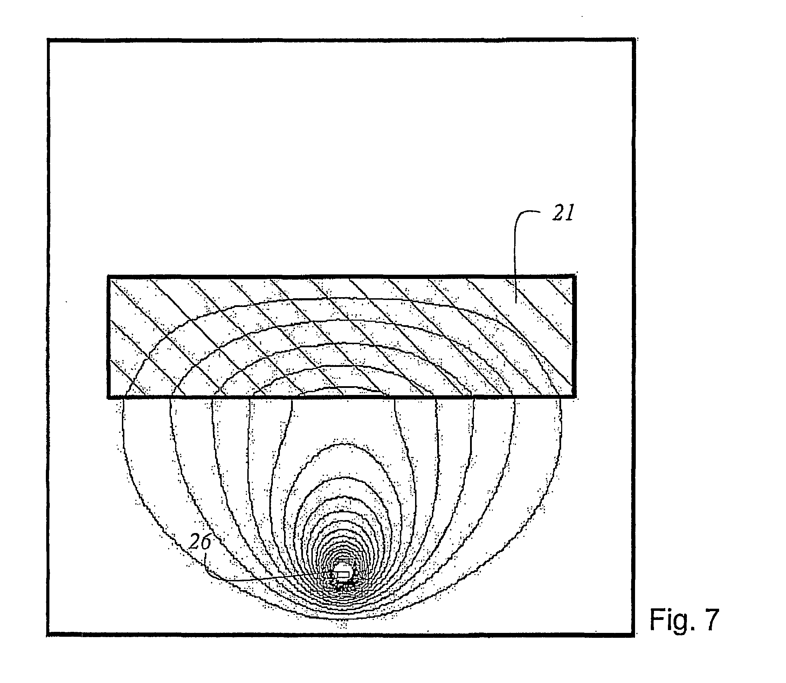

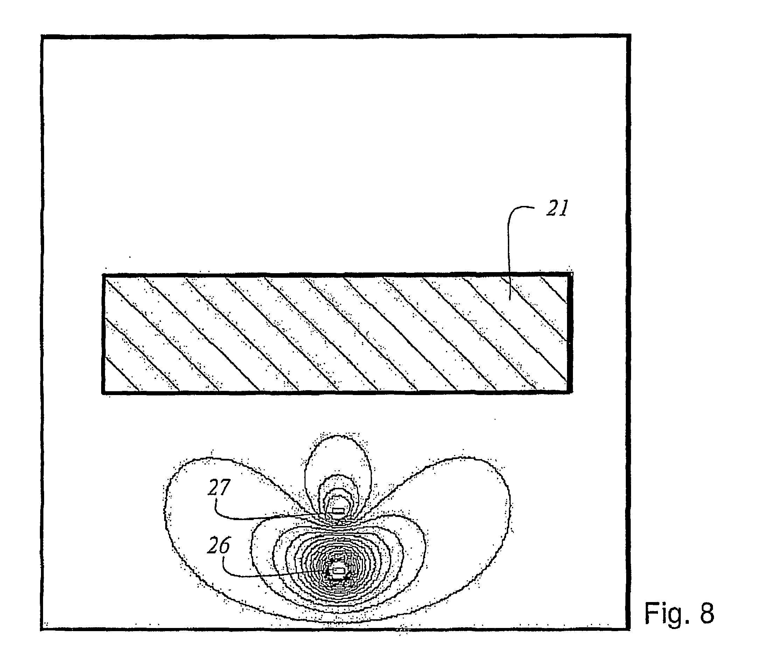

Fig.7 und Fig.8 zeigen eine Veranschaulichung der Wirkung einer Kompensationsspule 27 auf das magnetische Feld einer Korrekturspule 26. Durch den entgegengesetzten Stromfluss in beiden Spulen ist das summarische magnetische Feld beider Spulen außerhalb der Kompensationsspule in radialer Richtung nahezu unterdrückt (Fig.8), d.h. es durchdringt nicht weiter außen liegende Metallteile 21.

**Patentansprüche**

1. Korrekturlinsen-System für ein Partikelstrahl-Projektionsgerät mit mindestens einer ersten und einer zweiten magnetischen Linse (20a, 20b) und mehreren Korrekturlinsen zur Korrektur von Rotations-, Vergrößerungs- und Fokussierfehlern eines Partikelstrahl-Bildfeldes, **dadurch gekennzeichnet, dass**

   die mehreren Korrekturlinsen jeweils als Korrekturlinsenpaare (23, 24, 25) ausgebildet und zwischen der ersten und der zweiten magnetischen Linse (20a, 20b) und dem Partikelstrahl (1) angeordnet sind, wobei jedes Korrekturlinsenpaar (23, 24, 25) eine schnellen Korrekturspule (26) und eine Kompensationsspule (27) zur Unterdrükkung des Magnetfeldes von der Achse (1) weg nach außen aufweist, um durch Minimierung von wirbelstrombedingten Hystereseeffekten in umgebenden Ferromagnetika (21) schnelle und hochgenaue Korrekturvorgänge der Korrekturlinsenpaare (23, 24, 25) zu erreichen.

2. Korrekturlinsen-System nach Anspruch 1, **dadurch gekennzeichnet, dass** ein erstes, ein zweites und ein drittes Korrekturlinsenpaar (23, 24, 25) vorgesehen ist.

3. Korrekturlinsensystem nach Anspruch 1 und 2 **dadurch gekennzeichnet, dass** im Partikeloptik-Projektionsgerät, Fokussierung, Abbildungsmeßstab und Drehung unabhängig voneinander einstellbar sind.

4. Korrekturlinsen-System nach Anspruch 1, **dadurch gekennzeichnet, dass** die Korrekturspule (26) eines jeden Korrekturlinsenpaares (23, 24, 25) näher zum Partikelstrahl (1) angeordnet ist als die der Korrekturlinse (26) zugeordneten Kompensationsspule (27)

5. Korrekturlinsen-System nach einem der Ansprüche 1 bis 4, **dadurch gekennzeichnet, dass** die einzelnen Kompensationsspulen (27) und die Korrekturspulen (26) eines jeden Korrekturlinsenpaares (23, 24, 25) als Luftspulen ausgebildet sind.

6. Korrekturlinsen-System nach einem der Ansprüche 1 bis 5,
   **dadurch gekennzeichnet, dass** die Kompensationsspulen (27) einen Radius $R_{kom}$ und die Korrekturspulen (26) einen Radius $R_{fl}$ aufweisen, und dass das Verhältnis der Radien $R_{kom}/R_{fl}$, einen Wert zwischen 1,5 und 3,0 besitzt.

7. Korrekturlinsen-System nach Anspruch 6, **dadurch gekennzeichnet, dass** der Wert für das Verhältnis der Radien $R_{kom}/R_{fl}$ zwei beträgt.

8. Korrekturlinsen-System nach Anspruch 1 bis 7, **dadurch gekennzeichnet, dass** die Spulenpaare einzeln oder gemeinsam durch Ferritringe in Richtung der optischen Achse und/oder durch Ferritzylinder in radialer Richtung nach außen abgeschirmt sind.

**Claims**

1. A correction lens system for a particle beam projection device comprising at least a first and a second magnetic lens (20a, 20b) and a plurality of correction lenses for correcting rotation errors, magnification errors and focusing errors of a particulate beam image field, **characterised in that**
   the plurality of correction lenses are provided as correction lens pairs (23, 24, 25) and arranged between the first magnetic lens and the second magnetic lens (20a, 20b) and the particle beam (1), each correction lens pair (23, 24, 25) comprising a fast correction coil (26) and a compensation coil (27) to suppress the magnetic field towards the outside, away from the axis (1), in order to achieve fast and highly accurate correction processes of the correction lens pairs (23, 24, 25) by minimising hysteresis effects caused by eddy currents in surrounding ferromagnetic materials (21).

2. The correction lens system according to claim 1, **characterised in that** a first, a second and a third correction lens pair (23, 24, 25) are provided.

3. The correction lens system according to claims 1 and 2, **characterised in that** focusing, imaging scale and rotation are adjustable independently in the particle optics projection device.

4. The correction lens system according to claim 1, **characterised in that** the correction coil (26) of each correction lens pair (23, 24, 25) is arranged closer to the particle beam (1) than the compensation coil (27) associated with the correction lens (26).

5. The correction lens system according to any one of claims 1 to 4, **characterised in that** the individual compensation coils (27) and the correction coils (26) of each correction lens pair (23, 24, 25) are provided as air coils.

6. The correction lens system according to any one of claims 1 to 5, **characterised in that** the compensation coils (27) have a radius $R_{kom}$ and the correction

coils (26) have a radius $R_{fl}$, and **in that** the ratio of the radii $R_{kom}/R_{fl}$ has a value of between 1.5 and 3.0.

7. The correction lens system according to claim 6, **characterised in that** the value for the ratio of the radii $R_{kom}/R_{fl}$ is two.

8. The correction lens system according to claims 1 to 7, **characterised in that** the coil pairs are externally shielded individually or jointly by ferrite rings in the direction of the optical axis and/or by ferrite cylinders in a radial direction.

## Revendications

1. Système de lentilles correctrices pour un dispositif de projection à faisceau de particules comprenant au moins une première et une deuxième lentille magnétique (20a, 20b) et une pluralité de lentilles correctrices destinées à corriger des erreurs de rotation, de magnification et de focalisation du champ d'image d'un faisceau de particules, **caractérisé en ce que** ladite pluralité de lentilles correctrices se présentent sous forme de paires de lentilles correctrices (23, 24, 25) qui sont disposées entre lesdites première et deuxième lentilles magnétiques (20a, 20b) et ledit faisceau de particules (1), chacune desdites paires de lentilles correctrices (23, 24, 25) comprenant une bobine de correction rapide (26) et une bobine de compensation (27) pour supprimer le champ magnétique vers l'extérieur, à l'opposée de l'axe (1), afin d'obtenir des processus de correction rapides et très précises desdites paires de lentilles correctrices (23, 24, 25) en minimisant des effets d'hystérèse produits par des courants de Foucault dans des matériaux ferromagnétiques (21) environnants.

2. Système de lentilles correctrices selon la revendication 1, **caractérisé en ce que** l'on prévoit une première, une deuxième et une troisième paire de lentilles correctrices (23, 24, 25).

3. Système de lentilles correctrices selon les revendications 1 et 2, **caractérisé en ce que** la focalisation, l'échelle de reproduction et la rotation sont réglables de manière indépendante dans le dispositif de projection à système optique de particules.

4. Système de lentilles correctrices selon la revendication 1, **caractérisé en ce que** la bobine de correction (26) de chaque paire de lentilles correctrices (23, 24, 25) est disposée plus proche du faisceau de particules (1) que la bobine de compensation (27) associée à la lentille correctrice (26).

5. Système de lentilles correctrices selon l'une quelconque des revendications 1 à 4, **caractérisé en ce que** les bobines de compensation (27) individuelles et les bobines de correction (26) de chaque paire de lentilles correctrices (23, 24, 25) sont des bobines à air.

6. Système de lentilles correctrices selon l'une quelconque des revendications 1 à 5, **caractérisé en ce que** les bobines de compensation (27) présentent un rayon $R_{kom}$ et les bobines de correction (26) présentent un rayon $R_{fl}$, et **en ce que** le rapport des rayons $R_{kom}/R_{fl}$ présente une valeur entre 1,5 et 3,0.

7. Système de lentilles correctrices selon la revendication 6, **caractérisé en ce que** la valeur du rapport des rayons $R_{kom}/R_{fl}$ est deux.

8. Système de lentilles correctrices selon les revendications 1 à 7, **caractérisé en ce que** les paires de bobines sont blindées vers l'extérieur, individuellement ou ensemble, par des anneaux de ferrite en direction de l'axe optique et/ou par des cylindres de ferrite en direction radiale.

Fig. 1

EP 1 738 391 B1

Fig. 2

6a

20b

20

21

20a

21

6

28

1

Fig. 3

Fig. 4

Maßstabsänderung [1/A]

Fig. 5

EP 1 738 391 B1

Fig. 6

EP 1 738 391 B1

Fig. 7

Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0870316 B1
- US 6222197 B1